# EUROPEAN PATENT APPLICATION

(11) **EP 4 693 404 A1**
(43) Date of publication of application: **11.02.2026**
(21) Application number: 24778684.1
(22) Date of filing: 05.02.2024
(51) Int. Cl.: H01L 27/146

(54) **LIGHT DETECTION DEVICE**

(30) Priority: 31.03.2023 JP 2023059227
(71) Applicant: Sony Semiconductor Solutions Corporation, Atsugi-shi, Kanagawa 243-0014 (JP)
(72) Inventor: OHKUBO, Tomohiro, Atsugi-shi, Kanagawa 243-0014 (JP); TOGASHI, Hideaki, Atsugi-shi, Kanagawa 243-0014 (JP); KAWAI, Nobuhiro, Atsugi-shi, Kanagawa 243-0014 (JP); ITOH, Shinya, Atsugi-shi, Kanagawa 243-0014 (JP)
(74) Representative: Müller Hoffmann & Partner
(86) International application number: PCT/JP2024/003738
(87) International publication number: WO 2024/202539

(57) **Abstract**

A photodetector includes: a first photoelectric conversion element provided on a light incident side of a first base and converting incident light into electric charge; and a second photoelectric conversion element provided to overlap with the first photoelectric conversion element in the first base and including a multiplication region that multiplies a carrier generated by light.

## Description

### Technical Field

The present disclosure relates to a photodetector.

### Background Art

Patent Literature 1 discloses a solid-state imaging apparatus. The solid-state imaging apparatus has a stacked structure including a first photoelectric conversion region that photoelectrically converts received visible light and a second photoelectric conversion region that photoelectrically converts received infrared light.

It is possible for the solid-state imaging apparatus configured in this way to generate an infrared light image with a high resolution, while maintaining high image quality of a visible light image.

### Citation List

### Patent Literature

Patent Literature 1: Japanese Unexamined Patent Application Publication No. 2017-208496

### Summary of the Invention

A solid-state imaging apparatus is available for measurement of a distance, by using infrared light. As general ranging methods, a structured light (Structured Light) method, an indirect time of flight (i-ToF) method, a direct time of flight (d-ToF) method, and the like are known.

In the meantime, although a second photoelectric conversion region that photoelectrically converts infrared light is formed using a photodiode and is suitable for short-distance measurement, the second photoelectric conversion region is not suitable for intermediate-distance and long-distance measurement. Therefore, there is a demand for development of a photodetector that makes it possible to improve a ranging range.

A photodetector according to a first implementation of the present disclosure includes: a first photoelectric conversion element provided on a light incident side of a first base and converting incident light into electric charge; and a second photoelectric conversion element provided to overlap with the first photoelectric conversion element in the first base and including a multiplication region that multiplies a carrier generated by a photon.

A photodetector according to a second implementation of the present disclosure corresponds to the photodetector according to the first implementation, further including a light shield body provided along a periphery of the second photoelectric conversion element as viewed from the light incident side, the light shield body passing through at least the first base in a thickness direction and blocking the carrier generated from the second photoelectric conversion element.

A photodetector according to a third implementation of the present disclosure includes: a first base including a first semiconductor substrate, and a first insulating layer stacked on the first semiconductor substrate; a second photoelectric conversion element provided in the first base and including a multiplication region that multiplies a carrier generated by a photon; and a light shield body provided along a periphery of the second photoelectric conversion element as viewed from a light incident side, the light shield body passing through at least the first semiconductor substrate in a thickness direction and blocking the carrier generated from the second photoelectric conversion element.

### Brief Description of the Drawings

[FIG. 1] FIG. 1 is a vertical cross-sectional diagram of a main portion of a photodetector according to a first embodiment of the present disclosure.
[FIG. 2] FIG. 2 is a planar configuration diagram of the main portion of the photodetector illustrated in FIG. 1 (planar configuration diagram cut along A-A cut line illustrated in FIG. 1).
[FIG. 3] FIG. 3 is a planar configuration diagram of the main portion of the photodetector illustrated in FIG. 1 (planar configuration diagram cut along B-B cut line illustrated in FIG. 1).
[FIG. 4] FIG. 4 is a planar configuration diagram of the main portion of the photodetector illustrated in FIG. 1 (planar configuration diagram cut along C-C cut line illustrated in FIG. 1).
[FIG. 5] FIG. 5 is an enlarged vertical cross-sectional configuration diagram in which the main portion of the photodetector illustrated in FIG. 1 is enlarged.
[FIG. 6] FIG. 6 is a circuit diagram of a first photoelectric conversion element of the photodetector illustrated in FIG. 1 and a reading circuit thereof.
[FIG. 7] FIG. 7 is a circuit diagram of a second photoelectric conversion element of the photodetector illustrated in FIG. 1 and a reading circuit thereof.
[FIG. 8] FIG. 8 is a first process cross-sectional diagram corresponding to FIG. 5 for explaining a method of manufacturing the photodetector according to the first embodiment for each process.
[FIG. 9] FIG. 9 is a second process cross-sectional diagram.
[FIG. 10] FIG. 10 is a third process cross-sectional diagram.
[FIG. 11] FIG. 11 is a fourth process cross-sectional diagram.
[FIG. 12] FIG. 12 is a fifth process cross-sectional diagram.
[FIG. 13] FIG. 13 is a sixth process cross-sectional diagram.
[FIG. 14] FIG. 14 is a seventh process cross-sectional diagram.
[FIG. 15] FIG. 15 is an eighth process cross-sectional diagram.
[FIG. 16] FIG. 16 is an enlarged vertical cross-sectional configuration diagram corresponding to FIG. 5 of a photodetector according to a second embodiment of the present disclosure.
[FIG. 17] FIG. 17 is an enlarged vertical cross-sectional configuration diagram corresponding to FIG. 5 of a photodetector according to a third embodiment of the present disclosure.
[FIG. 18] FIG. 18 is an enlarged vertical cross-sectional configuration diagram corresponding to FIG. 5 of a photodetector according to a fourth embodiment of the present disclosure.
[FIG. 19] FIG. 19 is a vertical cross-sectional configuration diagram corresponding to FIG. 17 of a photodetector according to a fifth embodiment of the present disclosure.
[FIG. 20] FIG. 20 is a planar configuration diagram corresponding to FIG. 3 of the photodetector illustrated in FIG. 19.
[FIG. 21] FIG. 21 is an enlarged vertical cross-sectional configuration diagram corresponding to FIG. 5 of a photodetector according to a sixth embodiment of the present disclosure.
[FIG. 22] FIG. 22 is an enlarged vertical cross-sectional configuration diagram in which a main portion of the photodetector illustrated in FIG. 21 is enlarged.
[FIG. 23] FIG. 23 is an enlarged vertical cross-sectional configuration diagram corresponding to FIG. 22 of a photodetector according to a seventh embodiment of the present disclosure.
[FIG. 24] FIG. 24 is a planar configuration diagram corresponding to FIG. 4 of a photodetector according to an eighth embodiment of the present disclosure.
[FIG. 25] FIG. 25 is a block diagram depicting an example of schematic configuration of a vehicle control system.
[FIG. 26] FIG. 26 is a diagram of assistance in explaining an example of installation positions of an outside-vehicle information detecting section and an imaging section.
[FIG. 27] FIG. 27 is a view depicting an example of a schematic configuration of an endoscopic surgery system.
[FIG. 28] FIG. 28 is a block diagram depicting an example of a functional configuration of a camera head and a camera control unit (CCU).

### Modes for Carrying Out the Invention

Hereinafter, embodiments of the present disclosure are described in detail with reference to the drawings. It is to be noted that description is given in the following order.

### 1. First Embodiment

A first embodiment is a first example in which the present technique is applied to a photodetector. In the first embodiment, a configuration of a pixel, a configuration of a circuit, and a manufacturing method of the photodetector are described. In particular, in the first embodiment, a configuration of a photoelectric conversion element, a configuration of a shield, and a method of manufacturing these are described.

### 2. Second Embodiment

A second embodiment is a second example in which a configuration of a shield is changed in the solid-state imaging apparatus according to the first embodiment

### 3. Third Embodiment

A third embodiment is a third example in which a configuration of a shield is changed in the solid-state imaging apparatus according to the first embodiment.

### 4. Fourth Embodiment

A fourth embodiment is a fourth example in which a configuration of a shield is changed in the solid-state imaging apparatus according to the first embodiment.

### 5. Fifth Embodiment

A fifth embodiment is a fifth example in which a configuration of a shield is changed in the solid-state imaging apparatus according to the third embodiment.

### 6. Sixth Embodiment

A sixth embodiment is a sixth example in which a configuration of a shield is changed in the solid-state imaging apparatus according to the first embodiment.

### 7. Seventh Embodiment

A seventh embodiment is a seventh example in which a configuration of a shield is changed in the solid-state imaging apparatus according to the first embodiment.

### 8. Eighth Embodiment

An eighth embodiment is an eighth example including a shield body, in the solid-state imaging apparatus according to the first embodiment.

### 9. Application Example to Mobile Body

In this application example, an example in which the present technique is applied to a vehicle control system that is an example of a mobile body control system is described.

### 10. Application Example to Endoscopic Surgery System

In this application example, an example in which the present technique is applied to an endoscopic surgery system is described.

### 11. Other Embodiments

### <1. First Embodiment>

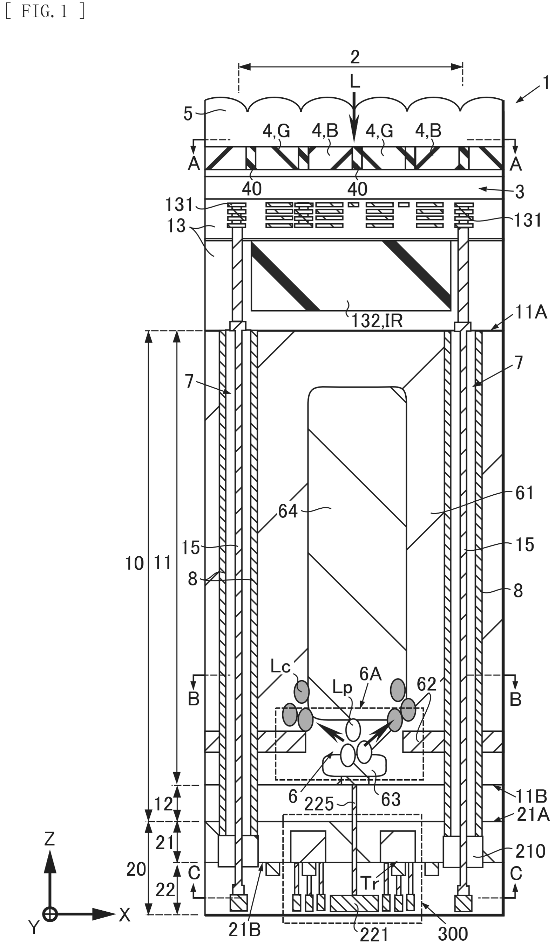

A photodetector 1 according to a first embodiment of the present disclosure is described with reference to FIGs. 1 to 15.

Here, in the figures, an arrow X direction illustrated indicates a single planar direction of the photodetector 1 placed on a plane for convenience, as appropriate. An arrow Y direction indicates another single planar direction orthogonal to the arrow X direction. Furthermore, an arrow Z direction indicates an upward direction orthogonal to the arrow X direction and the arrow Y direction. That is, the arrow X direction, the arrow Y direction, and the arrow Z direction respectively and exactly match an X-axis direction, a Y-axis direction, and a Z-axis direction of a three-dimensional coordinate system. Furthermore, an opposite direction of the arrow Z direction is a light incident direction L.

Note that each of these directions is indicated for easy understanding of the description and does not limit a direction of the present technique.

### [Configuration of Photodetector 1]

### (1) Circuit Configuration of Photodetector 1

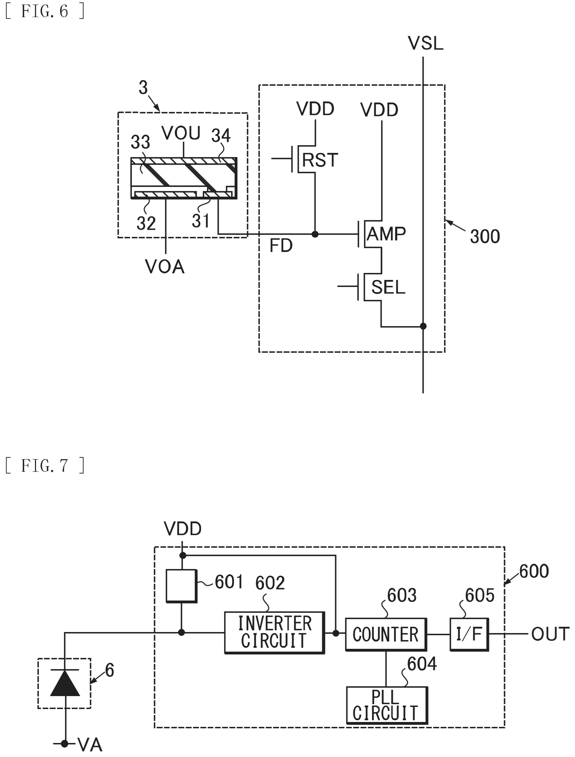

FIG. 6 illustrates an example of a circuit configuration of a first photoelectric conversion element 3 of the photodetector according to the first embodiment and a reading circuit 300 thereof. FIG. 7 illustrates an example of a circuit configuration of a second photoelectric conversion element 6 of the photodetector 1 and a reading circuit 600 thereof.

The photodetector 1 according to the first embodiment includes two types including the first photoelectric conversion element 3 and the second photoelectric conversion element 6, as illustrated in FIGs. 6 and 7. As illustrated in FIG. 6, the first photoelectric conversion element 3 is electrically coupled to the reading circuit 300. On the other hand, as illustrated in FIG. 7, the second photoelectric conversion element 6 is electrically coupled to the reading circuit 600.

Hereinafter, details are described.

### (1-1) Circuit Configuration of First Photoelectric Conversion Element 3 and Reading Circuit 300

As illustrated in FIG. 6, the first photoelectric conversion element 3 includes a first electrode 31, a photoelectric conversion layer 33, and a second electrode 34. Moreover, the first photoelectric conversion element 3 includes an electric charge accumulation and transfer layer 32. The first photoelectric conversion element 3 converts incident light into electric charge.

Here, the first electrode 31 is provided away from the electric charge accumulation and transfer layer 32. The photoelectric conversion layer 33 is stacked on the first electrode 31 and the electric charge accumulation and transfer layer 32 and is provided over the first electrode 31 and the electric charge accumulation and transfer layer 32. The second electrode 34 is provided on a side of the photoelectric conversion layer 33 opposite to the first electrode 31. A specific material of each component of the first photoelectric conversion element 3 or the like is described later in detail.

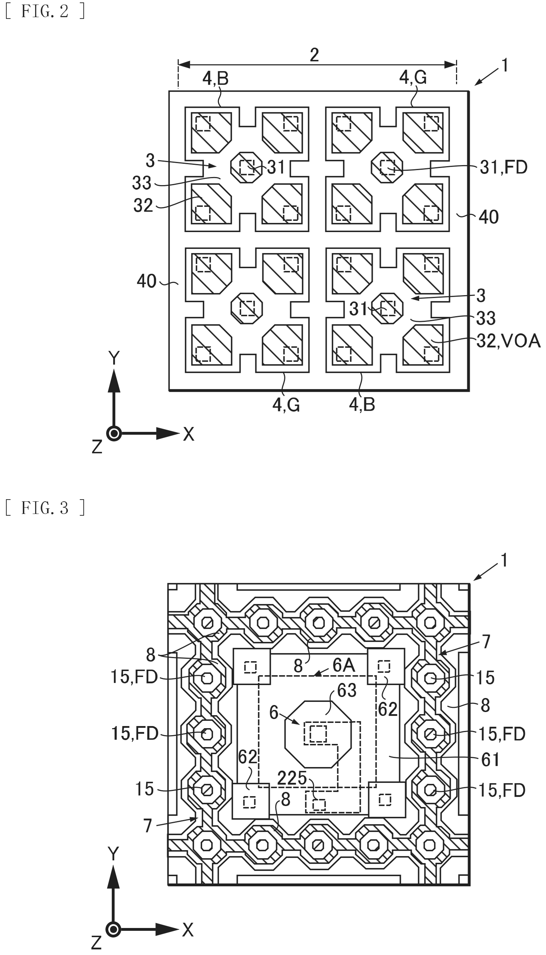

The one or more first photoelectric conversion elements 3 construct a single pixel 2. In the first embodiment, the four first photoelectric conversion elements 3 in total, including the two first photoelectric conversion elements 3 adjacent to each other in the arrow X direction and the two first photoelectric conversion elements 3 adjacent to each other in the arrow Y direction construct the single pixel 2 (refer to FIG. 2).

Note that, in the first embodiment, the single pixel 2 may be constructed, for example, by the two first photoelectric conversion elements 3, the eight first photoelectric conversion elements 3, or the like.

The first electrode 31 of the first photoelectric conversion element 3 is electrically coupled to the reading circuit 300 with a floating diffusion FD interposed therebetween. The reading circuit 300 is able to read the electric charge resulting from conversion from light by the first photoelectric conversion element 3.

The second electrode 34 is electrically coupled to a power supply voltage VOU to which a fixed voltage is supplied.

The electric charge accumulation and transfer layer 32 is electrically coupled to a drive signal circuit (not illustrated). To the electric charge accumulation and transfer layer 32, a drive signal VOA is supplied from the drive signal circuit.

The reading circuit 300 includes a reset transistor RST, an amplification transistor AMP, and a selection transistor SEL.

One of a pair of main electrodes of the reset transistor RST is electrically coupled to the floating diffusion FD. Another main electrode is electrically coupled to a power supply voltage VDD. A reset signal is supplied to a gate electrode.

One of a pair of main electrodes of the amplification transistor AMP is electrically coupled to the power supply voltage VDD. Another main electrode is electrically coupled to one of a pair of main electrodes of the selection transistor SEL. The floating diffusion FD is electrically coupled to the gate electrode.

Another main electrode of the selection transistor SEL is electrically coupled to an output signal line (vertical signal line) VSL. A selection signal is supplied to the gate electrode.

A transistor such as the reset transistor RST includes an insulated gate field effect transistor (IGFET: Insulated Gate Field Effect Transistor). The IGFET is used to include a metal oxide semiconductor field effect transistor (MOSFET) and a metal insulator semiconductor field effect transistor (MISFET).

### (1-2) Circuit Configuration of Second Photoelectric Conversion Element 6 and Reading Circuit 600

As illustrated in FIG. 7, the second photoelectric conversion element 6 includes a single photon avalanche diode (hereinafter, simply referred to as "SPAD (single photon avalanche diode)". The SPAD has a doubling region that doubles a carrier generated by a photon. Furthermore, the SPAD includes an anode region and a cathode region.

An anode voltage VA is supplied to the anode region of the SPAD. The anode voltage VA is a large negative voltage that makes avalanche multiplication occur, in other words, a voltage equal to or higher than a breakdown voltage. The anode voltage VA is, for example, a voltage of - 20 V.

The second photoelectric conversion element 6 may be constructed by using an avalanche photo diode (APD: Avalanche Photo Diode), a silicon photomultiplier (SiPM: Silicon Photomultiplier), or the like that operates in a non-linear region, instead of the SPAD.

The second photoelectric conversion element 6 is electrically coupled to the reading circuit 600. That is, the cathode region of the SPAD is coupled to the reading circuit 600. To the cathode region of the second photoelectric conversion element 6, for example, 1 V clamped on a side of the reading circuit 600 is applied.

Here, the reading circuit 600 includes a quench (Quench) element 601, an inverter 602, a counter 603, a phase locked loop (PLL: Phase Locked Loop) 604, and an interface circuit 605. Here, the quench element 601 draws an avalanche current and makes the reading circuit 600 be in a reset state.

Note that the second photoelectric conversion element 6 may be coupled to the reading circuit 600 with a protection circuit (not illustrated) interposed therebetween.

Furthermore, the interface circuit 605 is electrically coupled to, for example, a time measurement circuit (not illustrated). It is possible for the photodetector 1 to construct a ranging system, including the time measurement circuit.

### (2) Device Configuration of Photodetector 1

Next, a specific device configuration of the photodetector 1 is described.

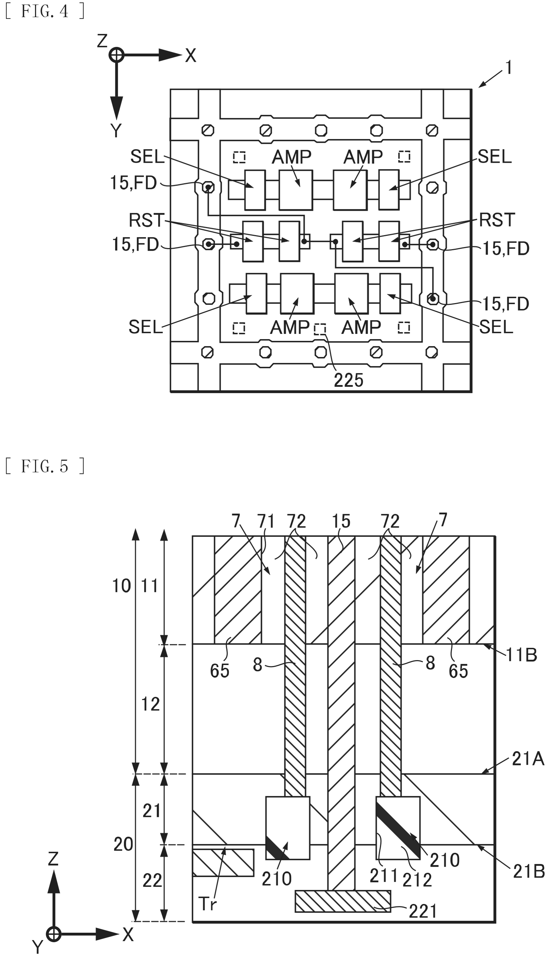

FIG. 1 illustrates an example of a vertical cross-sectional configuration corresponding to the single pixel 2 of the photodetector 1. FIG. 2 illustrates an example of a planar configuration of the first photoelectric conversion element 3 of the photodetector 1. FIG. 3 illustrates an example of a planar configuration of the second photoelectric conversion element 6 of the photodetector 1. Moreover, FIG. 4 illustrates an example of a planar configuration of the reading circuit 300 of the photodetector 1.

As illustrated in FIG. 1, the photodetector 1 includes a first base 10 and a second base 20. The first base 10 is stacked on the second base 20 in the arrow Z direction. In other words, each of the first base 10 and the second base 20 is sequentially provided in the light incident direction L.

### (2-1) Configuration of First Base 10

The first base 10 includes a first semiconductor substrate 11, and a first insulating layer 12 provided on a surface 11B of the first semiconductor substrate 11 on a side opposite to the arrow Z direction.

In the first embodiment, for the first semiconductor substrate 11, a single crystal silicon (Si) substrate is used. More specifically, the single crystal Si substrate is formed to be an n-type as a first conductivity type, and a p-type well region as a second conductivity type is formed in a predetermined region of the single crystal Si substrate. Here, the predetermined region is, for example, a region where the second photoelectric conversion element 6 is provided.

Furthermore, as the first semiconductor substrate 11, it is possible to use one or more substrates selected from among crystal Si, amorphous Si, microcrystal Si, crystalline selenium, amorphous selenium, and CuInGaSe (CIGS), CuInSe₂ (CIS), CuInS₂, CuAlS₂, CuAlSe₂, CuGaS₂, CuGaSe₂, AgAlS₂, AgAlSe₂, AgInS₂, and AgInSe₂ that are chalcopyrite-based compounds.

Moreover, as the first semiconductor substrate 11, it is possible to use one or more compound semiconductor substrates selected from among GaAs, InP, AlGaAs, InGaP, AlGaInP, InGaAsP, CdSe, CdS, In₂Se₃, In₂S₃, Bi₂Se₃, Bi₂S₃, ZnSe, ZnS, PbSe, and PbS that are group III-V compound semiconductors.

The first insulating layer 12 electrically separates the first semiconductor substrate 11 from the second base 20. For the first insulating layer 12, for example, it is possible to use SiO₂.

### (2-2) Configuration of Second Base 20

The second base 20 includes a second semiconductor substrate 21 and a second insulating layer 22 provided on a surface 21B of the second semiconductor substrate 21 on the side opposite to the arrow Z direction. The first base 10 is stacked on a surface 21A of the second semiconductor substrate 21 in the arrow Z direction.

In the first embodiment, a single crystal Si substrate is used for the second semiconductor substrate 21, similarly to the first semiconductor substrate 11. Moreover, in the first embodiment, a transistor Tr such as the reset transistor RTS that constructs the reading circuit 300 is provided on the second semiconductor substrate 21. In the second insulating layer 22, a wiring line 221 or the like is provided.

Furthermore, as the second semiconductor substrate 21, it is possible to use one or more substrates selected from among crystal Si, amorphous Si, microcrystal Si, crystalline selenium, amorphous selenium, and CuInGaSe (CIGS), CuInSe₂ (CIS), CuInS₂, CuAlS₂, CuAlSe₂, CuGaS₂, CuGaSe₂, AgAlS₂, AgAlSe₂, AgInS₂, and AgInSe₂ that are chalcopyrite-based compounds.

Moreover, as the second semiconductor substrate 21, it is possible to use one or more compound semiconductor substrates selected from among GaAs, InP, AlGaAs, InGaP, AlGaInP, InGaAsP, CdSe, CdS, In₂Se₃, In₂S₃, Bi₂Se₃, Bi₂S₃, ZnSe, ZnS, PbSe, and PbS that are group III-V compound semiconductors.

In addition, as the second semiconductor substrate 21, it is possible to use a substrate formed by using one or more materials selected from among a quantum dot including the materials described above, an oxide semiconductor material such as IGZO, transition metal di-chalcogenide, silicon carbide, diamond, graphene, carbon nanotube, and an organic semiconductor material such as a condensation polycyclic hydrocarbon compound or a condensed heterocycle compound. The IGZO is, for example, an oxide semiconductor including In, G), Zu, and O.

That is, in a case where the second semiconductor substrate 21 is formed using a material other than microcrystal Si, the transistor Tr is formed on a substrate formed using these materials as a base.

Although not illustrated in detail, the second insulating layer 22 is formed as an interlayer insulating film of a wiring layer in which the plurality of layers of wiring lines 221 is provided. For the second insulating layer 22, for example, it is possible to use the SiO₂.

### (2-3) Configuration of First Photoelectric Conversion Element 3

As illustrated in FIG. 1, the first photoelectric conversion element 3 is provided on the first base 10. More specifically, the first photoelectric conversion element 3 is provided on a surface 11A of the first semiconductor substrate 11 in the arrow Z direction with an insulating layer 13 interposed therebetween. Although simplified in FIG. 1, as illustrated in FIGs. 6 and 2, the first photoelectric conversion element 3 includes the first electrode 31, the photoelectric conversion layer 33, and the second electrode 34 and further includes the electric charge accumulation and transfer layer 32.

### (2-3-1) Configuration of First Electrode 31

As illustrated in FIGs. 1, 2, and 6, the first electrode 31 is provided on a side of the photoelectric conversion layer 33 closer to the first base 10. The first electrode 31 is used as a reading electrode or a lower electrode and is arranged for each first photoelectric conversion element 3. The first electrode 31 is coupled to the reading circuit 300 via each of a wiring line 131 and a through wiring line 15 to be described later.

For the first electrode 31, for example, indium zinc oxide (IZO: Indium Zinc Oxide) or indium tin oxide (ITO: Indium Tin Oxide) having conductivity and transparency is used. A film thickness of the first electrode 31 is, for example, equal to or more than 10 nm and equal to or less than 100 nm.

### (2-3-2) Configuration of Photoelectric Conversion Layer 33

The photoelectric conversion layer 33 is provided in the arrow Z direction of the first electrode 31. In the first embodiment, for the photoelectric conversion layer 33, an organic material is used. As the organic material, it is possible to use any one of a p-type organic semiconductor, an n-type organic semiconductor, a stacked structure of the p-type organic semiconductor and the n-type organic semiconductor, and a mixture (bulk hetero structure) of the p-type organic semiconductor and the n-type organic semiconductor.

The stacked structure includes a stacked structure in which each of the p-type organic semiconductor, the mixture (bulk hetero structure) of the p-type organic semiconductor and the n-type organic semiconductor, and the n-type organic semiconductor is stacked. Furthermore, the stacked structure includes a stacked structure in which each of the p-type organic semiconductor and the mixture (bulk hetero structure) of the p-type organic semiconductor and the n-type organic semiconductor is stacked. Moreover, the stacked structure includes a stacked structure in which each of the n-type organic semiconductor and the mixture (bulk hetero structure) of the p-type organic semiconductor and the n-type organic semiconductor is stacked. Note that it is possible to appropriately change an order of stacking of the stacked structure.

As the p-type organic semiconductor, it is possible to use a naphthalene derivative, a anthracene derivative, a phenanthrene derivative, a pyrene derivative, a perylene derivative, a tetracene derivative, a pentacene derivative, a quinacridone derivative, a thiophen derivative, a thienothiophene derivative, a benzothiophene derivative, a benzothienobenzothiophene derivative, a triallylamine derivative, a carbazole derivative, a perylene derivative, a picene derivative, a chrysene derivative, a fluoranthene derivative, a phthalocyanine derivative, a subphthalocyanine derivative, a subporphyrazine derivative, a metal complex using a heterocyclic compound as a ligand, a polythiophen derivative, a polybenzothiadiazole derivative, a polyfluorene derivative, or the like.

As the n-type organic semiconductor, it is possible to use a fullerene and a fullerene derivative (for example, fullerene (higher order fullerene) such as C60, C70, or C74, endohedral fullerene, or the like), a fullerene derivative (for example, fullerene fluoride, PCBM fullerene compound, fullerene multimer, or the like)), an organic semiconductor having a larger (deeper) HOMO and LUMO than the p-type organic semiconductor, or transparent inorganic metal oxide.

As the n-type organic semiconductor, specifically, it is possible to use a heterocyclic compound containing a nitrogen atom, an oxygen atom, and a sulfur atom. As the heterocyclic compound, for example, it is possible to use an organic molecule containing a pyridine derivative, a pyrazine derivative, a pyrimidine derivative, a triazine derivative, a quinoline derivative, a quinoxaline derivative, an isoquinoline derivative, an acridine derivative, a phenazine derivative, a phenanthroline derivative, a tetrazole derivative, a pyrazole derivative, an imidazole derivative, a thiazole derivative, an oxazole derivative, an imidazole derivative, a benzimidazole derivative, a benzotriazole derivative, a benzoxazole derivative, a carbazole derivative, a benzofuran derivative, a dibenzofuran derivative, a subporphyrazine derivative, a polyphenylene vinylene derivative, a polybenzothiadiazole derivative, a polyfluorene derivative, or the like, in a portion of a molecular frame, an organic metal complex, or a subphthalocyanine derivative.

As a group included in the fullerene derivative, it is possible to use a halogen atom; a linear, branched, or cyclic alkyl group or phenyl group; a group containing a linear or condensed aromatic compound; a group containing halide; a partial fluoroalkyl group; a perfluoroalkyl group; a silylalkyl group; a silyl alkoxy group; an arylsilyl group; an arylsulfanyl group; an alkylsulphanyl group; an arylsulfonyl group; an alkylsulfonyl group; an allylic sulfide group; an alkyl sulfide group; an amino group; an alkylamino group; an arylamino group; a hydroxy group; an alkoxy group; an acylamino group; an acyloxy group; a carbonyl group; a carboxy group; a carboxamide group; a carboalkoxy group; an acyl group; a sulfonyl group; a cyano group; a nitro group; a group containing chalcogenide; a phosphine group; a phosphon group; and derivatives of these.

Although a thickness of the photoelectric conversion layer 33 formed using the organic material is not limited, for example, the thickness is equal to or more than 1 × 10⁻⁸ m and equal to or less than 6 × 10⁻⁷ m. The thickness of the photoelectric conversion layer 33 is preferably equal to or more than 1 × 10⁻⁷ and equal to or less than 4.5 × 10⁻⁷.

Note that the most organic semiconductors are classified into a p-type and an n-type. The p-type means that a hole is easily transported. The n-type means that an electron is easily transported. Therefore, an interpretation is not limited to an interpretation that a hole or an electron is included as a majority carrier of thermal excitation, as in the inorganic semiconductor.

Then, in the first embodiment, the photoelectric conversion layer 33 generates electric charge by photoelectric conversion from each of light with a green wavelength and light with a blue wavelength.

In a case where the light with the green wavelength is photoelectrically converted, as an organic material forming the photoelectric conversion layer 33, for example, it is possible to use a rhodamine series pigment, a merocyanine series pigment, a quinacridone derivative, a subphthalocyanine series pigment (subphthalocyanine derivative), or the like.

In a case where the light with the blue wavelength is photoelectrically converted, as the organic material forming the photoelectric conversion layer 33, for example, it is possible to use a coumaric acid pigment, tris-8-hydroxyquinoli aluminum (Alq3), a merocyanine series pigment, or the like.

Furthermore, in the first embodiment, the photoelectric conversion layer 33 may extract information in an entire visible light range, by further adding a configuration that generates light with a red wavelength by photoelectric conversion. In a case where the light with the red wavelength is photoelectrically converted, as the organic material forming the photoelectric conversion layer 33, for example, it is possible to use a phthalocyanine series pigment or a subphthalocyanine series pigment (subphthalocyanine derivative).

Moreover, the photoelectric conversion layer 33 may be constructed using an inorganic photoelectric conversion layer. In this case, as an inorganic material used to construct the inorganic photoelectric conversion layer, it is possible to use one or more selected from among crystal Si, amorphous Si, microcrystal Si, crystalline selenium, amorphous selenium, a chalcopyrite-based compound, and a group III-V compound semiconductor.

The chalcopyrite-based compound includes CuInGaSe (CIGS), CuInSe₂ (CIS), CuInS₂, CuAlS₂, CuAlSe₂, CuGaS₂, CuGaSe₂, AgAlS₂, AgAlSe₂, AgInS₂, or AgInSe₂.

The group III-V compound semiconductor includes GaAs, InP, AlGaAs, InGaP, AlGaInP, InGaAsP, or the like. Moreover, the group III-V compound semiconductor includes CdSe, CdS, In₂Se₃, In₂S₃, Bi₂Se₃, Bi₂S₃, ZnSe, ZnS, PbSe, PbS, or the like.

In addition, it is possible to use a quantum dot including these materials for the photoelectric conversion layer 33.

Furthermore, although not illustrated, it is possible for the photoelectric conversion layer 33 to have a stacked structure of each of a lower semiconductor layer and an upper photoelectric conversion layer. By including the lower semiconductor layer in the photoelectric conversion layer 33, it is possible for the photoelectric conversion layer 33 to prevent recombination at the time of electric charge accumulation and to improve electric charge transfer efficiency to the electric charge accumulation and transfer layer 32. Moreover, it is possible to effectively suppress generation of a dark current.

As the upper photoelectric conversion layer, it is possible to appropriately select a material from among various materials forming the photoelectric conversion layer 33 described above.

On the other hand, as the lower semiconductor layer, it is preferable to use a material having a large bandgap value (for example, bandgap value equal to or more than 3.0 eV) and having higher mobility than the material forming the photoelectric conversion layer 33. Specifically, it is possible to use an oxide semiconductor material such as IGZO, transition metal di-chalcogenide, silicon carbide, diamond, graphene, carbon nanotube, and an organic semiconductor material such as a condensation polycyclic hydrocarbon compound or a condensed heterocycle compound.

Furthermore, as the lower semiconductor layer, in a case where the accumulated electric charge is an electron, it is possible to use a material having an ionization potential larger than an ionization potential of the material forming the photoelectric conversion layer 33.

On the other hand, as the lower semiconductor layer, in a case where the accumulated electric charge is a hole, it is possible to use a material having an electron affinity smaller than an electron affinity of the material forming the photoelectric conversion layer 33.

Furthermore, in the material forming the lower semiconductor layer, it is preferable that an impurity concentration be, for example, equal to or less than 1 × 10¹⁸ cm⁻³. The lower semiconductor layer may have a single-layer structure or a multi-layer structure. Furthermore, the material forming the lower semiconductor layer may differ for each of a region corresponding to the first electrode 31 and a region corresponding to the floating diffusion FD.

### (2-3-3) Configuration of Second Electrode 34

The second electrode 34 is provided on the side of the photoelectric conversion layer 33 opposite to the first electrode 31. The second electrode 34 is used as a common electrode or an upper electrode and is arranged over the plurality of first photoelectric conversion elements 3 and the plurality of pixels 2.

The second electrode 34 is formed using an electrode material having conductivity and transparency, similarly to the first electrode 31. The second electrode 34 is formed, for example, using an electrode material such as ITO or IZO. Furthermore, the second electrode 34 may be formed using one or more electrode materials selected from among IGZO, IAZO, ITZO, IGSiO, ZnO, AZO, and GZO.

A film thickness of the second electrode 34 is, for example, equal to or more than 10 nm and equal to or less than 100 nm.

### (2-3-4) Configuration of Electric Charge Accumulation and Transfer Layer 32

The electric charge accumulation and transfer layer 32 is provided between the first electrode 31 and the photoelectric conversion layer 33. More specifically, the photoelectric conversion layer 33 is provided with an insulator (reference numeral is omitted) interposed therebetween, on the first electrode 31. Here, the electric charge accumulation and transfer layer 32 is provided over the plurality of pixels 2.

Here, the insulator (reference numeral is omitted) is used as a gate insulator film. As the insulator, for example, one or more insulating materials selected from among SiO₂, SiON, AlO, and HfO is used.

The electric charge accumulation and transfer layer 32 accumulates the electric charge generated by photoelectric conversion from light by the photoelectric conversion layer 33. The drive signal VOA is supplied to the electric charge accumulation and transfer layer 32 through each of the wiring line 131 and the through wiring line 15.

The electric charge accumulation and transfer layer 32 is formed using an oxide semiconductor which is a transparent semiconductor. More specifically, for the electric charge accumulation and transfer layer 32, for example, IGZO is used. Furthermore, for the electric charge accumulation and transfer layer 32, it is possible to use IAZO including In, Al, Zn, and O or ITZO including In, Sn, Zn, and O. Moreover, for the electric charge accumulation and transfer layer 32, it is possible to use one or more semiconductor materials selected from among IGSiO, ZnO, AZO, GZO, ITO, and IZO.

A thickness of the electric charge accumulation and transfer layer 32 is, for example, equal to or more than 10 nm and equal to or less than 100 nm.

### (2-4) Configuration of Optical Filter 4

As illustrated in FIGs. 1 and 2, in the arrow Z direction of the first photoelectric conversion element 3, an optical filter 4 is provided with a protection film (reference numeral is omitted) interposed therebetween. The optical filter 4 is provided for each first photoelectric conversion element 3.

A planar shape of the single pixel 2 is formed in a rectangle, as viewed from an incident light L direction (hereinafter, simply referred to as "in planar view"). A planar shape of the first photoelectric conversion element 3 is formed in a rectangle that is smaller than the pixel 2 and is similar to the planar shape of the pixel 2.

In the single pixel 2, on the two first photoelectric conversion elements 3 provided in a direction of one diagonal line, the optical filter 4 that transmits light in a green wavelength band is arranged. This optical filter 4 is denoted with a reference numeral "G".

Furthermore, in the single pixel 2, on the two first photoelectric conversion elements 3 provided in a direction of another diagonal line, the optical filter 4 that transmits light in a blue wavelength band is arranged. This optical filter 4 is denoted with a reference numeral "B".

The optical filter 4 is formed including, for example, color that colors a resin material. More specifically, as a resin, it is possible to practically use an organic resin material, for example, a phthalocyanine derivative or the like.

Furthermore, a partition wall 40 is provided between the optical filters 4. The partition wall 40 is formed to allow to surround a periphery of a side surface of the optical filter 4. The partition wall 40 is able to effectively suppress or prevent light leakage from one of the adjacent optical filters 4 to the other optical filter 4.

### (2-5) Configuration of Optical Lens 5

As illustrated in FIG. 1, an optical lens 5 is provided on a side of the optical filter 4 opposite to the first photoelectric conversion element 3. Although not illustrated, the optical lens 5 is formed in a circular state for each first photoelectric conversion element 3, in planar view. Furthermore, the optical lens 5 is formed in a curved shape that is curved toward the light incident direction L as viewed in the arrow Y direction (hereinafter, simply referred to as "in a side view"), and collects the incident light.

That is, the optical lens 5 is a so-called on-chip lens and is integrally formed over the plurality of first photoelectric conversion elements 3. The optical lens 5 is formed using, for example, a transparent resin material.

### (2-6) Configuration of Second Photoelectric Conversion Element 6

As illustrated in FIGs. 1 and 3, the second photoelectric conversion element 6 is provided in the first semiconductor substrate 11 of the first base 10, overlapping with the first photoelectric conversion element 3, in a region of the pixel 2. That is, the first photoelectric conversion element 3 is stacked on the second photoelectric conversion element 6, in the light incident direction L. Furthermore, in other words, each of the first photoelectric conversion element 3 and the second photoelectric conversion element 6 is vertically stacked in the arrow Z direction.

Then, a separator 7 is provided along and around a side surface of the second photoelectric conversion element 6. The separator 7 is arranged between the pixels 2, in planar view and electrically and optically separates between the adjacent second photoelectric conversion elements 6.

The second photoelectric conversion element 6 is a SPAD in the first embodiment. The second photoelectric conversion element 6 includes an anode region 62 and a cathode region 63.

The anode region 62 is provided in a peripheral region on a side of the surface 11B of the first semiconductor substrate 11 and along the separator 7, in a well region 61 formed on the first semiconductor substrate 11. The well region 61 is set to be the p-type, and the anode region 62 is formed using a p-type semiconductor region having higher impurity concentration than the well region 61. Although detailed description is omitted, the anode voltage VA is supplied to the anode region 62, via a wiring line.

The cathode region 63 is provided on a side of the surface 11B of the first semiconductor substrate 11 and in a middle region of the well region 61. The cathode region 63 is formed using an n-type semiconductor region. A cathode voltage is supplied to the cathode region 63.

As illustrated in FIG. 1, in the second photoelectric conversion element 6, a multiplication region 6A is constructed at a junction between the anode region 62 and the cathode region 63. In the multiplication region 6A, it is possible to multiplicate carriers (here, electron) Lc generated by inputting photons Lp.

Furthermore, in the middle region of the well region 61, a drift region 64 is provided toward the side of the surface 11A of the first semiconductor substrate 11. The drift region 64 is formed using an n-type semiconductor region and relaxes a drift field.

### (2-7) Configuration of Separator 7

The separator 7 includes a groove 71 and an embedded body 72. Note that, in the well region 61, a pinning region 65 is provided along the separator 7. The pinning region 65 is formed using a p-type semiconductor region having higher impurity concentration than the well region 61.

The groove 71 is provided along and around a side surface of the second photoelectric conversion element 6, in planar view. Furthermore, the groove 71 is formed to allow to extend through from the surface 11A of the first semiconductor substrate 11 toward the surface 11B in the thickness direction of the first semiconductor substrate 11, in a side view.

The embedded body 72 is embedded in the groove 71. The embedded body 72 is formed using an insulating material that electrically separates at least between the adjacent second photoelectric conversion elements 6. In the first embodiment, as the embedded body 72, SiO₂ is used.

Furthermore, the embedded body 72 may be formed using one or more insulating materials selected from among tetraethoxysilane (TEOS), SiN, and SiON.

Furthermore, as the embedded body 72, it is possible to use one or more materials selected from among hafnium oxide (HfO), aluminum oxide (AlO), zirconium oxide (ZrO), tantalum oxide (TaO), and titanium oxide (TiO).

Furthermore, as an insulating material other than those described above, the embedded body 72 may include one or more materials selected from among lanthanum oxide (LaO), praseodymium oxide (PrO), cerium oxide (CeO), neodymium oxide (NdO), promethium oxide (PmO), samarium oxide (SmO), europium oxide (EuO), gadolinium oxide (GaO), terbium oxide (TbO), dysprosium oxide (DyO), holmium oxide (HoO), thulium oxide (TmO), ytterbium oxide (YbO), lutetium oxide (LuO), yttrium oxide (YO), aluminum nitride (AlN), hafnium oxynitride (HfON), and aluminum oxynitride (AlON).

### (2-8) Configuration of Wiring Line 131 and Optical Filter 132

On the surface 11A of the first semiconductor substrate 11 of the first base 10, the first photoelectric conversion element 3 is provided with the insulating layer 13 interposed therebetween. In the insulating layer 13, the plurality of layers of wiring lines 131 is provided on the side of the first photoelectric conversion element 3, and an optical filter 132 is provided on the side of the second photoelectric conversion element 6.

The insulating layer 13 is formed, for example, using an insulating material similar to that of the first insulating layer 12.

One end of the wiring line 131 is electrically coupled to the first photoelectric conversion element 3. Furthermore, another end of the wiring line 131 is electrically coupled to the through wiring line 15 to be described later. For the wiring line 131, the transparent electrode material described above is used.

Here, the single optical filter 132 is provided, for the four first photoelectric conversion elements 3 of the single pixel 2. A planar shape of the optical filter 132 is formed into a rectangle (not illustrated).

The optical filter 132 transmits infrared light. This optical filter 132 is denoted with a reference numeral "IR".

The optical filter 132 is formed using a material similar to that of the optical filter 4.

### (2-9) Configuration of Through Wiring Line 15

As illustrated in FIGs. 1 and 3, the plurality of through wiring lines 15 arranged at constant intervals is provided along the periphery of the second photoelectric conversion element 6. One end of the through wiring line 15 is electrically coupled to the first photoelectric conversion element 3 through the wiring line 131. Another end of the through wiring line 15 passes through at least the first semiconductor substrate 11 of the first base 10 in the thickness direction and is electrically coupled to the reading circuit 300. More specifically, the through wiring line 15 is extended to pass through the embedded body 72 of the separator 7.

Here, as illustrated in FIG. 3, the through wiring lines 15, provided on the left and the right of the pixel 2 in planar view and denoted with a reference numeral "FD", are used as the floating diffusions FD. The through wiring line 15 other than the above is used for a signal line that supplies the drive signal VOA or the like.

For the through wiring line 15, a Si material or a metal material having conductivity is used. As the Si material, for example, it is possible to use a Si material doped with impurities for obtaining conductivity such as phosphorus doped amorphous silicon (PDAS). As the metal material, for example, it is possible to use one or more metal materials selected from among Al, tungsten (W), titanium (Ti), cobalt (Co), hafnium (Hf), and tantalum (Ta).

Note that the through wiring line 15 may be coupled to the reading circuit 600, and in the present technique, one or both of "reading circuit 300" and "reading circuit 600" may be collectively and simply referred to as "circuit".

### (2-10) Configuration of Light Shield body 8

FIG. 5 illustrates an example of an enlarged vertical cross-sectional configuration of the light shield body 8 that is the main portion of the photodetector 1 illustrated in FIG. 1.

As illustrated in FIGs. 1, 3, and 5, the photodetector 1 includes the light shield body 8. The light shield body 8 is provided along the periphery of the second photoelectric conversion element 6 and to surround around the side surface of the second photoelectric conversion element 6, in planar view and in a side view.

More specifically, the light shield body 8 is provided between the second photoelectric conversion element 6 and the through wiring line 15 and is formed along a side wall of the groove 71 of the separator 7. The light shield body 8 is formed to allow to extend through at least the first semiconductor substrate 11 of the first base 10 in the thickness direction.

In other words, the light shield body 8 is formed using the groove 71 of the separator 7.

In the first embodiment, the light shield body 8 passes through the first semiconductor substrate 11 of the first base 10 in the thickness direction, further passes through the first insulating layer 12 of the first base 10 in the thickness direction, and is extended into the second semiconductor substrate 21 of the second base 20. A position of one end of the light shield body 8 in the arrow Z direction coincides with the surface 11A of the first semiconductor substrate 11. In the second semiconductor substrate 21, an element separator 210 that electrically separates between the transistors Tr is provided. A position of another end of the light shield body 8 on an opposite side to the arrow Z direction coincides with a bottom surface of the element separator 210 on the side of the arrow Z direction.

The light shield body 8 blocks the carrier Lc generated from the second photoelectric conversion element 6 and effectively suppresses or prevents leakage of the carrier Lc to the adjacent second photoelectric conversion element 6. Furthermore, because the light shield body 8 extends also to the side of the second base 20, the leakage of the carrier Lc to the transistor Tr is effectively suppressed or prevented.

The light shield body 8 includes a metal material that is superior in reflective performance or light shield performance to the carrier Lc. As this metal material, for example, it is possible to use one or more metal materials selected from among Al, W, Ti, Co, Hf, Ag, and Ta.

### (2-11) Configuration of Reading Circuit 300

For easy description, as illustrated in FIGs. 1 and 4, on the second semiconductor substrate 21 of the second base 20, the transistor Tr that constructs the reading circuit 300 is provided. As described above, in the first embodiment, the four first photoelectric conversion elements 3 are arranged for the single pixel 2. Therefore, as illustrated in FIG. 4, on the second semiconductor substrate 21, four pairs of the reset transistors RST, the amplification transistors AMP, and the selection transistors SEL provided in correspondence with the single first photoelectric conversion element 3 are provided.

Note that, as illustrated in FIG. 5, the element separator 210 provided between the transistors Tr includes a groove 211 formed from the surface 21B of the second semiconductor substrate 21 toward the surface 21A and an insulator 212 that is embedded in the groove 211 and has an insulation property.

### [Method of Manufacturing Photodetector 1]

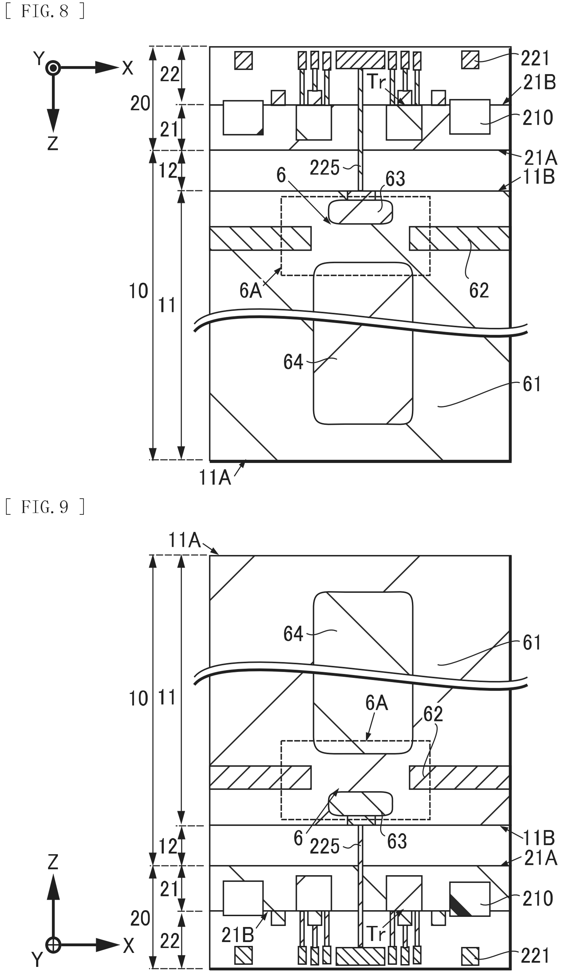

Next, a method of manufacturing the photodetector 1 described above is described with reference to FIGs. 8 to 15. FIGs. 8 to 15 illustrate an example of a series of process cross sections for explaining the method of manufacturing the photodetector 1 according to the first embodiment.

First, as illustrated in FIG. 8, the second base 20 is stacked on the first base 10, and the second photoelectric conversion element 6 of the first base 10 and the wiring line 221 of the second base 20 are electrically coupled to each other. Although only the main portion is illustrated in FIGs. 8 to 15, in the first base 10, the second photoelectric conversion element 6 is formed on the first semiconductor substrate 11, and the first insulating layer 12 is formed. Furthermore, in the second base 20, the transistor Tr is formed on the second semiconductor substrate 21, and the second insulating layer 22 is formed.

The second base 20 is bonded to a support substrate (not illustrated), and as illustrated in FIG. 9, the first semiconductor substrate 11 of the first base 10 is thinned. For this thinning, for example, a chemical mechanical polishing (CMP) method is used.

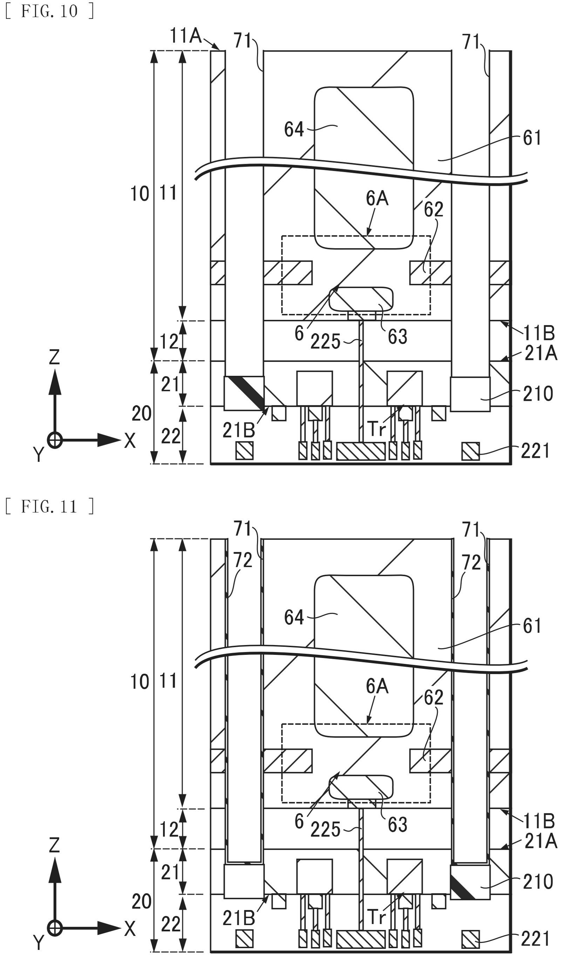

As illustrated in FIG. 10, around a formation region of the pixel 2, the groove 71 of the separator 7 is formed in the first base 10 and the second base 20. The groove 71 passes through the first semiconductor substrate 11 and the first insulating layer 12 from the surface 11A of the first semiconductor substrate 11 of the first base 10 in the thickness direction and is formed to reach an inner part of the second semiconductor substrate 21 of the second base 20. Here, the groove 71 is formed, to reach the bottom surface of the element separator 210 of the second base 20. To form the groove 71, an anisotropic etching method such as a reactive ion etching (RIE) method is used.

In other words, when the groove 71 is formed, the element separator 210 is used as an etching stopper.

As illustrated in FIG. 11, a first embedded body 72 is formed, along an inner wall and a bottom surface of the groove 71. As described above, the embedded body 72 is formed, for example, using SiO₂. The embedded body 72 is formed, for example, by an atomic layer deposition (ALD) method.

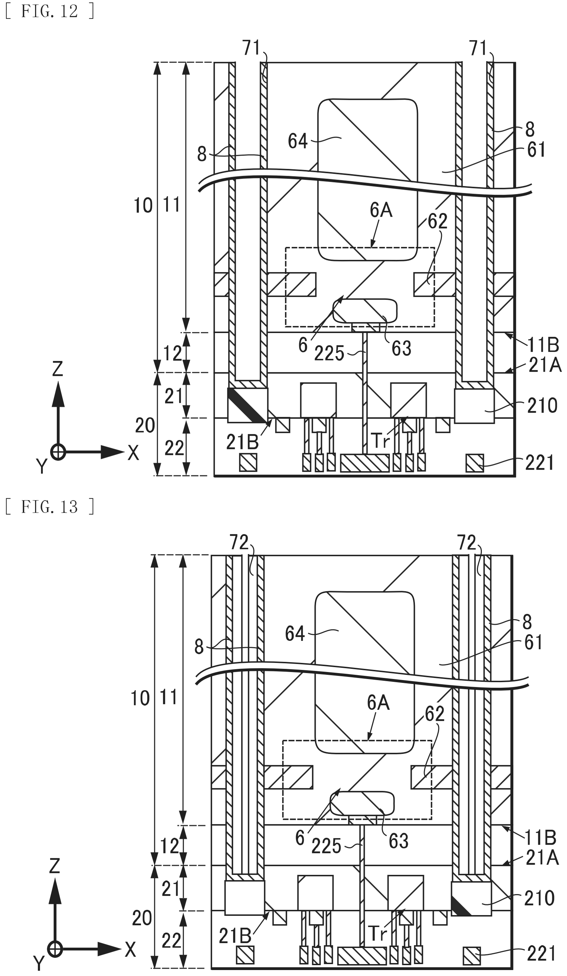

As illustrated in FIG. 12, the light shield body 8 is formed along at least the inner wall of the groove 71 with the embedded body 72 interposed therebetween. For the light shield body 8, for example, Al having high reflection characteristics with respect to light is used. The light shield body 8 is formed, for example, by the ALD method or a chemical vapor deposition (CVD) method.

As illustrated in FIG. 13, a second embedded body 72 is formed along the inner wall and the bottom surface of the groove 71 with the light shield body 8 interposed therebetween. The embedded body 72 is formed using the same insulating material as that of the first embedded body 72. Furthermore, the embedded body 72 may be formed using an insulating material different from that of the first embedded body 72.

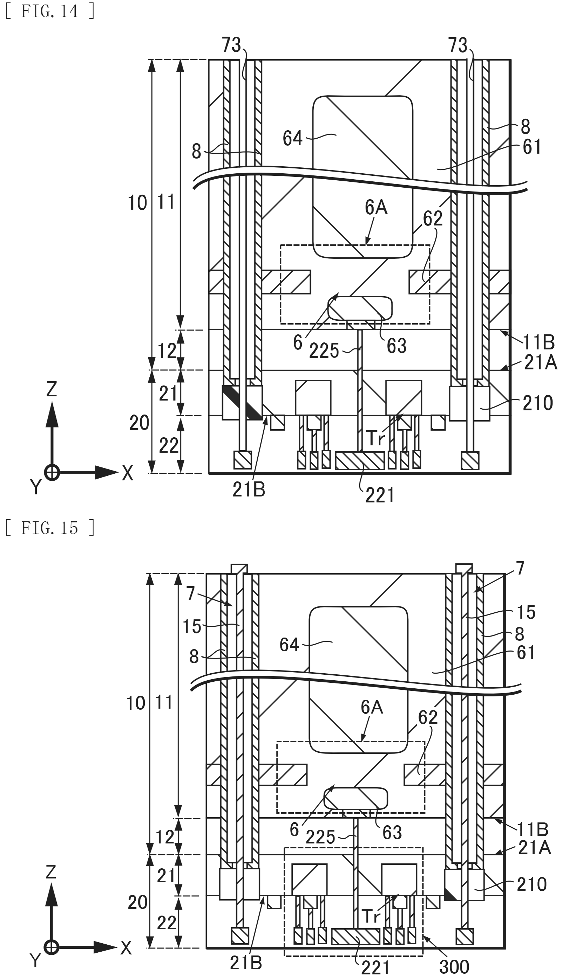

As illustrated in FIG. 14, a groove 73 that passes through each of the element separator 210 and the second semiconductor substrate 21 in the thickness direction and reaches the wiring line 221 is formed in a middle portion of the groove 71 in a groove width direction. The groove 73 is formed, for example, by the anisotropic etching method. Thereafter, an insulating film (reference numeral is omitted) is formed, to perform insulation and separation from the light shield body 8.

As illustrated in FIG. 15, the through wiring line 15 is formed that is embedded in the groove 73 and reaches the wiring line 221 of the second base 20 from the surface 11A of the first semiconductor substrate 11 of the first base 10. The through wiring line 15 is formed, for example, using Al. The through wiring line 15 is formed by the ALD method or the CVD method. Note that an unnecessary through wiring line 15 formed on the surface 11A of the first semiconductor substrate 11 is removed by an etching back method or the like

Thereafter, on the surface 11A of the first semiconductor substrate 11 of the first base 10, each of the optical filter 132, the wiring line 131, the first photoelectric conversion element 3, the optical filter 4, and the optical lens 5 is sequentially formed. When this process ends, the photodetector 1 illustrated in FIGs. 1 to 5 described above is completed.

### [Workings and Effect]

A described above, as illustrated in FIG. 1, the photodetector 1 according to the first embodiment includes the first photoelectric conversion element 3 and the second photoelectric conversion element 6.

The first photoelectric conversion element 3 is provided on the light incident side of the first base 10 and converts the incident light into the electric charge. The second photoelectric conversion element 6 is provided to overlap with the first photoelectric conversion element 3 in the first base 10 and includes the multiplication region 6A that multiplies the carrier generated by the light.

In other words, the first photoelectric conversion element 3 is stacked on the second photoelectric conversion element 6, in the light incident direction L.

In the photodetector 1 configured in this way, the first photoelectric conversion element 3 photoelectrically converts visible light, the second photoelectric conversion element 6 photoelectrically converts infrared light, and it is possible to acquire information regarding the visible light and ranging information. Therefore, it is possible for the photodetector 1 to obtain a wide ranging range and to improve the ranging range. Moreover, it is possible for the photodetector 1 to improve a signal-to-noise ratio (S/N ratio) when the ranging information is acquired, and in addition, to enlarge a dynamic range.

Furthermore, as illustrated in FIGs. 1, 3, and 5, the photodetector 1 includes light shield body 8. The light shield body 8 is provided along the periphery of the second photoelectric conversion element 6 in planar view and passes through at least the first semiconductor substrate 11 in the thickness direction. Then, the light shield body 8 is provided between the second photoelectric conversion element 6 and the through wiring line 15. The light shield body 8 blocks the carrier Lc generated from the second photoelectric conversion element 6.

According to the photodetector 1 configured in this way, it is possible to block the carrier Lc generated from the second photoelectric conversion element 6 by the light shield body 8. Therefore, it is possible to effectively suppress or prevent the leakage of the carrier Lc to the adjacent pixel 2.

Furthermore, in the photodetector 1, as illustrated in FIGs. 1 and 5, the light shield body 8 is extended into the second semiconductor substrate 21 of the second base 20.

Therefore, it is possible to effectively suppress or prevent the leakage of the carrier Lc generated from the second photoelectric conversion element 6 to the side of the second semiconductor substrate 21 by the light shield body 8. That is, it is possible to effectively suppress or prevent a malfunction of the reading circuit 300 or the like caused by the leakage of the carrier Lc.

Furthermore, in the method of manufacturing the photodetector 1, as illustrated in FIGs. 11 and 12, the light shield body 8 is formed using the groove 71 of the separator 7. Therefore, in the photodetector 1, it is possible to easily construct the light shield body 8.

Furthermore, as illustrated in FIGs. 1, 3, and 5, the photodetector 1 includes the first base 10, the second photoelectric conversion element 6, and the light shield body 8.

The first base 10 includes the first semiconductor substrate 11 and the first insulating layer 12 stacked on the first semiconductor substrate 11. The second photoelectric conversion element 6 is provided in the first base 10 and includes the multiplication region 6A that multiplies the carrier Lc generated by light. The light shield body 8 is provided along the periphery of the second photoelectric conversion element 6 in planar view, passes through at least the first semiconductor substrate 11 in the thickness direction, and blocks the carrier generated from the second photoelectric conversion element 6.

According to the photodetector 1 configured in this way, it is possible to block the carrier Lc generated from the second photoelectric conversion element 6 by the light shield body 8. Therefore, it is possible to effectively suppress or prevent the leakage of the carrier Lc to the adjacent pixel 2.

### <2. Second Embodiment>

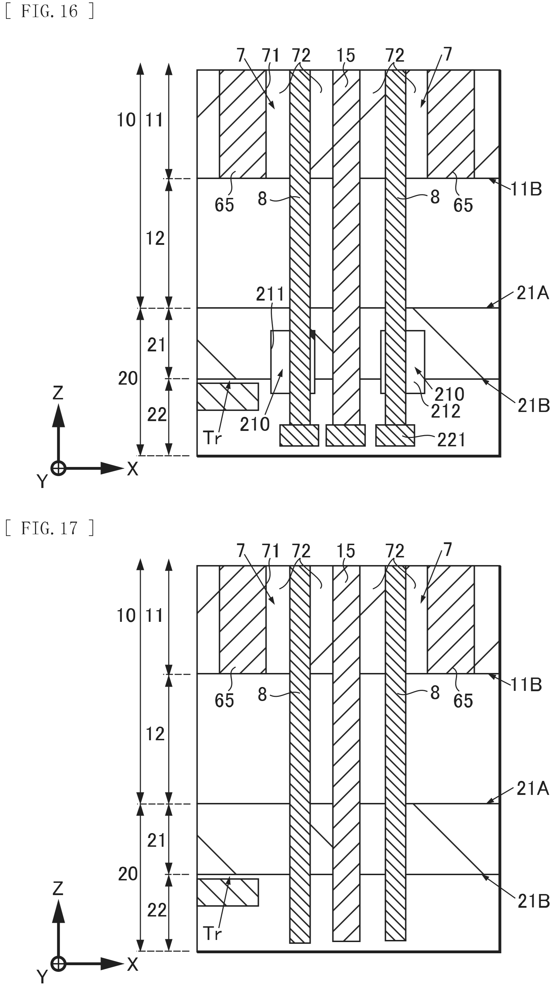

A photodetector 1 according to a second embodiment of the present disclosure is described with reference to FIG. 16.

Note that, in the second embodiment and subsequent embodiments, components same as or substantially same as those of the photodetector 1 according to the first embodiment are denoted with the same reference numeral, and overlapped description is omitted.

### [Configuration of Photodetector 1]

FIG. 16 illustrates an example of an enlarged vertical cross-sectional configuration of a light shield body 8 that is a main portion of the photodetector 1 according to the second embodiment.

As illustrated in FIG. 16, in the photodetector 1 according to the second embodiment, the light shield body 8 passes through a second semiconductor substrate 21 of the second base 20 in the thickness direction and is extended to reach the wiring line 221 of the second insulating layer 22. In other words, the light shield body 8 passes completely through the second semiconductor substrate 21 in the thickness direction.

Components other than the above are the same or substantially the same as the components of the photodetector 1 according to the first embodiment.

### [Workings and Effect]

It is possible for the photodetector 1 according to the second embodiment to obtain workings and an effect similar to the workings and the effect obtained by the photodetector 1 according to the first embodiment.

Furthermore, in the photodetector 1, as illustrated in FIG. 16, the light shield body 8 passes completely through the second semiconductor substrate 21 in the thickness direction.

Therefore, it is possible to more effectively suppress or prevent leakage of a carrier Lc generated from a second photoelectric conversion element 6 to a side of the second semiconductor substrate 21 by the light shield body 8, and it is possible to more effectively suppress or prevent a malfunction of the reading circuit 300 or the like caused by the leakage of the carrier Lc.

### <3. Third Embodiment>

A photodetector 1 according to a third embodiment of the present disclosure is described with reference to FIG. 17.

### [Configuration of Photodetector 1]

FIG. 17 illustrates an example an enlarged vertical cross-sectional configuration of a light shield body 8 that is a main portion of the photodetector 1 according to the third embodiment.

As illustrated in FIG. 17, in the photodetector 1 according to the third embodiment, the light shield body 8 passes completely through a second semiconductor substrate 21 of the second base 20 in the thickness direction. The light shield body 8 is extended to a predetermined position in the second insulating layer 22, with no limitation to the wiring line 221.

Components other than the above are the same or substantially the same as the components of the photodetector 1 according to the second embodiment.

### [Workings and Effect]

It is possible for the photodetector 1 according to the third embodiment to obtain workings and an effect similar to the workings and the effect obtained by the photodetector 1 according to the second embodiment.

### <4. Fourth Embodiment>

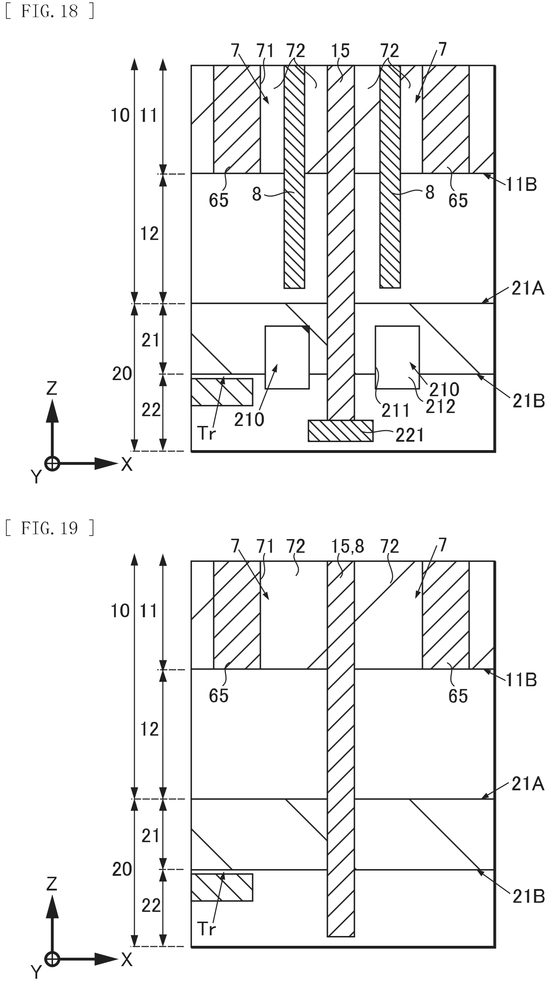

A photodetector 1 according to a fourth embodiment of the present disclosure is described with reference to FIG. 18.

### [Configuration of Photodetector 1]

FIG. 18 illustrates an example of an enlarged vertical cross-sectional configuration of a light shield body 8 that is a main portion of the photodetector 1 according to the fourth embodiment.

As illustrated in FIG. 18, in the photodetector 1 according to the fourth embodiment, the light shield body 8 is extended into the first insulating layer 12 of the first base 10. In other words, the light shield body 8 does not reach the second base 20.

Components other than the above are the same or substantially the same as the components of the photodetector 1 according to the second embodiment.

### [Workings and Effect]

It is possible for the photodetector 1 according to the fourth embodiment to obtain workings and an effect similar to the workings and the effect obtained by the photodetector 1 according to the first embodiment.

Furthermore, in the photodetector 1, as illustrated in FIG. 18, the light shield body 8 is extended only into the first insulating layer 12 of the first base 10 and does not reach the second base 20.

Therefore, an arrangement layout of the light shield body 8 does not affect a side of the second base 20. That is, an element arrangement layout of the reading circuit 300 of the second base 20 is freely made with respect to the arrangement layout of the light shield body 8.

### <5. Fifth Embodiment>

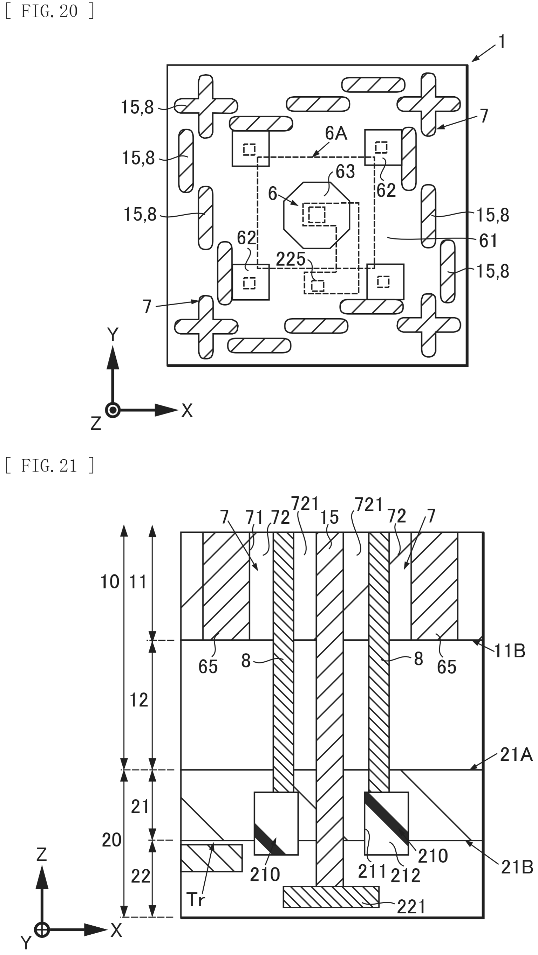

A photodetector 1 according to a fifth embodiment of the present disclosure is described with reference to FIGs. 19 and 20.

### [Configuration of Photodetector 1]

FIG. 19 illustrates an example of an enlarged vertical cross-sectional configuration of a light shield body 8 that is a main portion of the photodetector 1 according to the fifth embodiment. FIG. 20 illustrates an example of a planar configuration of the light shield body 8.

As illustrated in FIGs. 19 and 20, in the photodetector 1 according to the fifth embodiment, a plurality of through wiring lines 15 is arranged along a periphery of a second photoelectric conversion element 6, in planar view. One through wiring line 15 and another through wiring line 15 that are adjacent to each other in an arrangement direction are arranged with their respective portions overlapping with each other as viewed from the second photoelectric conversion element 6.

In other words, the plurality of through wiring lines 15 is arranged with no gaps therebetween as viewed from a middle position of a pixel 2. That is, the through wiring line 15 is configured as the light shield body 8 described in the photodetectors 1 according to the first to the fourth embodiments.

In the fifth embodiment, the light shield body 8 is extended into the second insulating layer 22 of the second base 20, similarly to the light shield body 8 of the photodetector 1 according to the third embodiment (refer to FIG. 17).

Note that the light shield body 8 may be extended into a second semiconductor substrate 21, similarly to the light shield body 8 of the photodetector 1 according to the first embodiment (refer to FIG. 5). Furthermore, the light shield body 8 may be extended into the first insulating layer 12 of the first base 10, similarly to the light shield body 8 of the photodetector 1 according to the second embodiment (refer to FIG. 18).

Components other than the above are the same or substantially the same as the components of the photodetectors 1 according to the first to the fourth embodiments.

### [Workings and Effect]

It is possible for the photodetector 1 according to the fifth embodiment to obtain workings and an effect similar to the workings and the effect obtained by any one of the photodetectors 1 according to the first to the fourth embodiments .

Furthermore, in the photodetector 1, as illustrated in FIGs. 19 and 20, the plurality of through wiring lines 15 is arranged along the periphery of the second photoelectric conversion element 6, in planar view and is formed as the light shield body 8 that blocks a carrier generated from the second photoelectric conversion element 6. Therefore, because it is possible to use the through wiring line 15 as the light shield body 8, it is possible to easily construct the light shield body 8.

### <6. Sixth Embodiment>

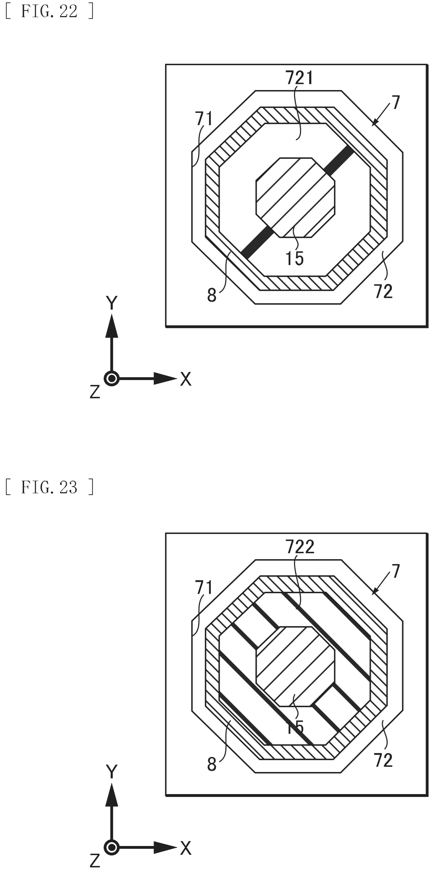

A photodetector 1 according to a sixth embodiment of the present disclosure is described with reference to FIGs. 21 and 22.

### [Configuration of Photodetector 1]

FIG. 21 illustrates an example of an enlarged vertical cross-sectional configuration of a light shield body 8 that is a main portion of the photodetector 1 according to the sixth embodiment. FIG. 22 illustrates an example of a planar configuration of the light shield body 8.

As illustrated in FIGs. 21 and 22, in the photodetector 1 according to the sixth embodiment, a portion of the embedded body 72 of the separator 7 that is between a through wiring line 15 and the light shield body 8 is formed as a first insulator 721. A withstand voltage of the first insulator 721 is higher than a withstand voltage of the first insulating layer 12.

Under such a condition, the first insulator 712 is appropriately selected from materials described as the embedded body 72 of the photodetector 1 according to the first embodiment.

Components other than the above are the same or substantially the same as the components of the photodetectors 1 according to the first to the fourth embodiments.

### [Workings and Effect]

It is possible for the photodetector 1 according to the sixth embodiment to obtain workings and an effect similar to the workings and the effect obtained by any one of the photodetectors 1 according to the first to the fourth embodiments.

Furthermore, in the photodetector 1, the first insulator 721 is provided between the through wiring line 15 and the light shield body 8. Therefore, it is possible to improve a withstand voltage between the through wiring line 15 and the light shield body 8.

### <7. Seventh Embodiment>

A photodetector 1 according to a seventh embodiment of the present disclosure is described with reference to FIG. 23.

### [Configuration of Photodetector 1]

FIG. 23 illustrates an example of a planar configuration of a light shield body 8 that is a main portion of the photodetector 1 according to the sixth embodiment.

As illustrated in FIG. 23, in the photodetector 1 according to the seventh embodiment, a portion of the embedded body 72 of the separator 7 that is between a through wiring line 15 and the light shield body 8 is formed as a second insulator 722. A permittivity of the second insulator 722 is lower than a permittivity of the first insulating layer 12.

Under such a condition, the second insulator 722 is appropriately selected from materials described as the embedded body 72 of the photodetector 1 according to the first embodiment.

Components other than the above are the same or substantially the same as the components of the photodetectors 1 according to the first to the fourth embodiments.

### [Workings and Effect]

It is possible for the photodetector 1 according to the seventh embodiment to obtain workings and an effect similar to the workings and the effect obtained by any one of the photodetectors 1 according to the first to the fourth embodiments.

Furthermore, in the photodetector 1, the second insulator 722 having a low permittivity is provided between the through wiring line 15 and the light shield body 8. Therefore, it is possible to reduce a parasitic capacitance to be applied to the through wiring line 15. In particular, because the through wiring line 15 is used as the floating diffusion FD, it is possible to improve a photoelectric conversion efficiency (refer to FIG. 6).

### <8. Eighth Embodiment>

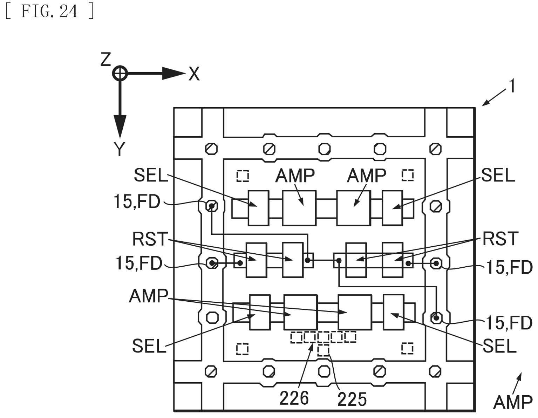

A photodetector 1 according to an eighth embodiment of the present disclosure is described with reference to FIG. 24.

### [Configuration of Photodetector 1]

FIG. 24 illustrates an example of a planar configuration of the photodetector 1 according to the eighth embodiment.

In the photodetector 1 according to the eighth embodiment, as illustrated in FIG. 24, a cathode electrode 225 that is electrically coupled to the cathode region 63 (refer to FIG. 1) of a SPAD that is a second photoelectric conversion element 6 is drawn around the reading circuit 300. Here, a shield body 226 surrounding the cathode electrode 225 is provided between the reading circuit 300 and the cathode electrode 225. The shield body 226 has an electrode structure similar to that of the cathode electrode 225.

In the eighth embodiment, the plurality of shield bodies 226 is arranged in the arrow X direction. A fixed potential is supplied to the shield body 226. This fixed potential is, for example, equal to or more than 0 V and equal to or less than 3 V.

Note that the plurality of shield bodies 226 may be integrally formed.

Components other than the above are the same as or substantially the same as the components of the photodetectors 1 according to the first to the seventh embodiments.

### [Workings and Effect]

It is possible for the photodetector 1 according to the eighth embodiment to obtain workings and an effect similar to the workings and the effect obtained by any one of the photodetectors 1 according to the first to the seventh embodiments.

Further, in the photodetector 1, as illustrated in FIG. 24, the shield bodies 226 are provided that surround the cathode electrode 225 of the second photoelectric conversion element 6 and to which the fixed potential is applied. Therefore, it is possible to effectively suppress or prevent an effect of a cathode voltage applied to the cathode electrode on surroundings.

### <9. Application Example to Mobile Body>

The technology according to the present disclosure (present technology) is applicable to various products. For example, the technology according to the present disclosure may be achieved in the form of an apparatus to be mounted to a mobile body of any kind such as an automobile, an electric vehicle, a hybrid electric vehicle, a motorcycle, a bicycle, a personal mobility, an airplane, a drone, a vessel, or a robot.

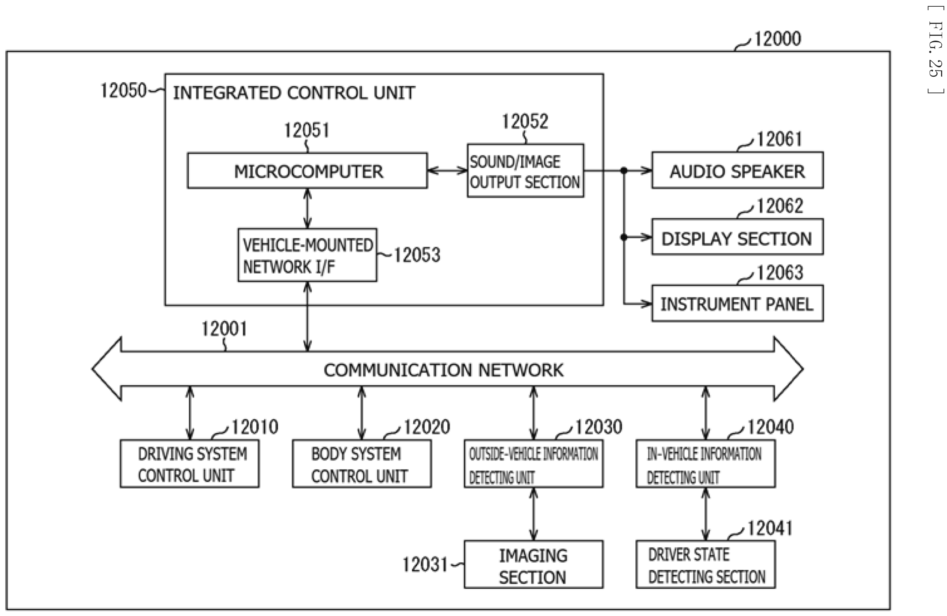

FIG. 25 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 25, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 25, an audio speaker 12061, a display section 12062, and an instrument panel 12063 are illustrated as the output device. The display section 12062 may, for example, include at least one of an on-board display and a head-up display.

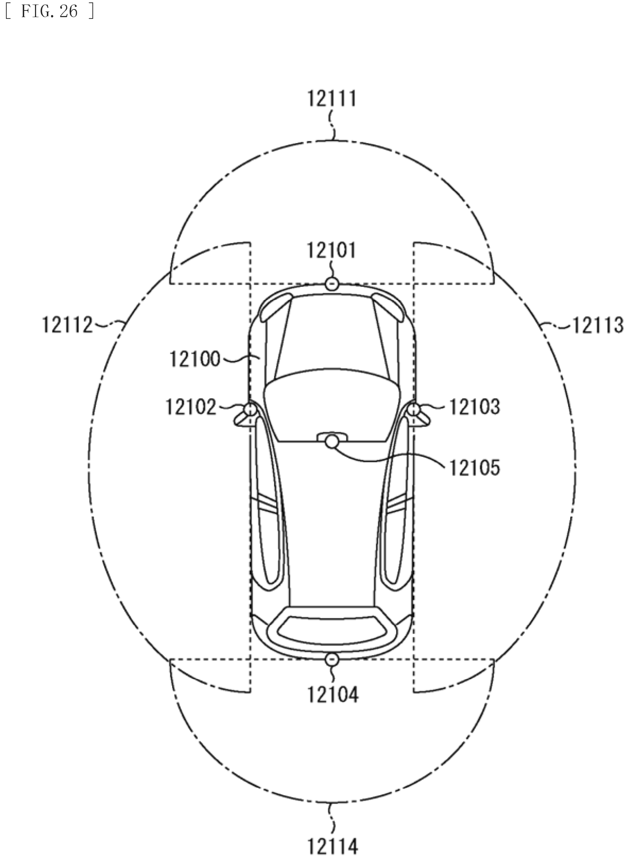

FIG. 26 is a diagram depicting an example of the installation position of the imaging section 12031.

In FIG. 26, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 26 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of one example of the vehicle control system, to which the technology according to the present disclosure may be applied. The technology according to the present disclosure may be applied to the imaging section 12031 among the configurations described above. The application of the technology according to the present disclosure to the imaging section 12031 makes it possible to achieve the imaging section 12031 that allows for an improvement in distance measurement range.

### <10. Application Example to Endoscopic Surgery System>

The technology according to the present disclosure (present technology) is applicable to various products. For example, the technology according to the present disclosure may be applied to an endoscopic surgery system.

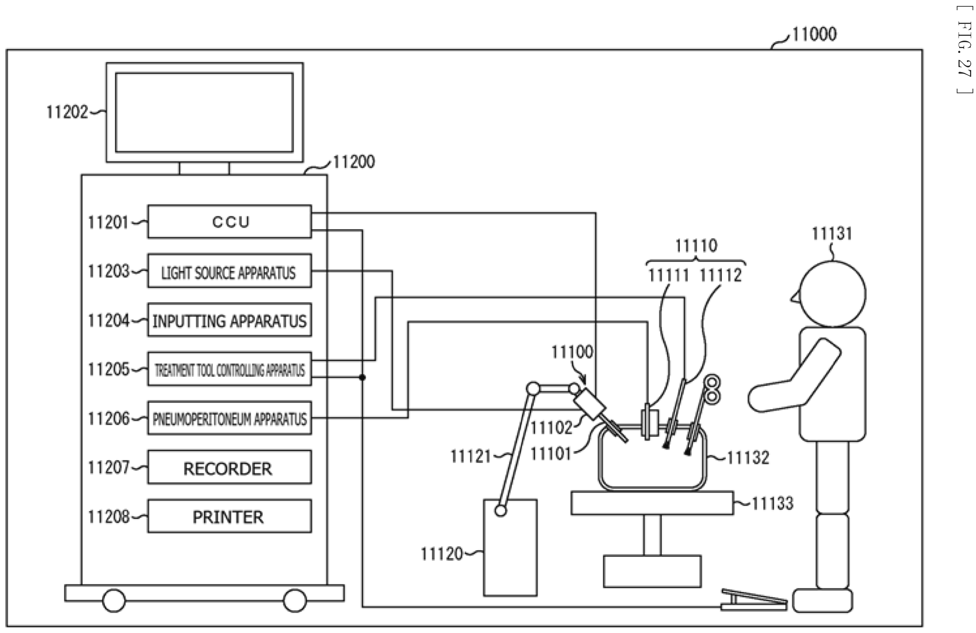

FIG. 27 is a view depicting an example of a schematic configuration of an endoscopic surgery system to which the technology according to an embodiment of the present disclosure (present technology) can be applied.

In FIG. 27, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

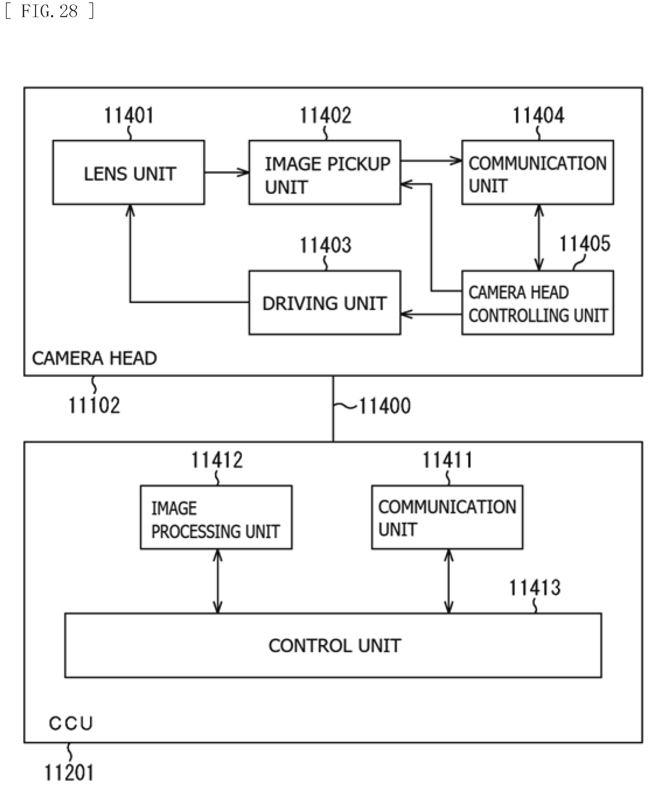

FIG. 28 is a block diagram depicting an example of a functional configuration of the camera head 11102 and the CCU 11201 depicted in FIG. 27.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of one example of the endoscopic surgery system, to which the technology according to the present disclosure may be applied. The technology according to the present disclosure may be applied to, for example, the image pickup unit 11402 among the configurations described above. The application of the technology according to the present disclosure to the image pickup unit 11402 makes it possible to achieve the image pickup unit 11402 that allows for an improvement in distance measurement range.

It is to be noted that although the endoscopic surgery system has been described as an example here, the technology according to the present disclosure may also be applied to, for example, a microscopic surgery system, and the like.

### < 11. Other Embodiments>

The present technique is not limited to the above embodiments, and various modifications are possible without departing from the scope of the present technique.

For example, the photodetectors according to the two or more embodiments, of the photodetectors according to the first to the eighth embodiments, may be combined.

A photodetector according to a first mode of the present disclosure includes a first photoelectric conversion element and a second photoelectric conversion element.

The first photoelectric conversion element is provided on a light incident side of a first base and converts incident light into electric charge. The second photoelectric conversion element is provided to overlap with the first photoelectric conversion element in the first base and includes a multiplication region that multiplies a carrier generated by the light.

In the photodetector configured in this way, visible light is photoelectrically converted by the first photoelectric conversion element, and infrared light is photoelectrically converted by the second photoelectric conversion element, and accordingly, it is possible to acquire information regarding the visible light and ranging information. Therefore, it is possible for the photodetector to obtain a wide ranging range and to improve the ranging range.

A photodetector according to a second mode of the present disclosure further includes a light shield body in the photodetector according to the first mode. The light shield body is provided along a periphery of the second photoelectric conversion element, as viewed from the light incident side, passes through at least the first base in the thickness direction, and blocks the carrier generated from the second photoelectric conversion element.

According to the photodetector configured in this way, it is possible to shield the carrier generated from the second photoelectric conversion element by the light shield body. Therefore, it is possible to effectively suppress or prevent leakage of the carrier to the adjacent second photoelectric conversion element.

A photodetector according to a third mode of the present disclosure includes the first base including the first semiconductor substrate and a first insulating layer stacked on the first semiconductor substrate, the second photoelectric conversion element that is provided in the first base and includes the multiplication region that multiplies the carrier generated by the light, and the light shield body that is provided along the periphery of the second photoelectric conversion element, as viewed from the light incident side, passes through at least the first semiconductor substrate in the thickness direction, and blocks the carrier generated from the second photoelectric conversion element.

According to the photodetector configured in this way, it is possible to shield the carrier generated from the second photoelectric conversion element by the light shield body. Therefore, it is possible to effectively suppress or prevent the leakage of the carrier to the adjacent second photoelectric conversion element.

### <Configuration of Present Technology>

The present technology has the following configuration. According to the present technology having the following configuration, it is possible for the photodetector to improve the ranging range.

(1) A photodetector including:
   a first photoelectric conversion element provided on a light incident side of a first base and converting incident light into electric charge; and
   a second photoelectric conversion element provided to overlap with the first photoelectric conversion element in the first base and including a multiplication region that multiplies a carrier generated by a photon.
(2) The photodetector according to (1), in which the first photoelectric conversion element is stacked on the second photoelectric conversion element in a light incident direction.
(3) The photodetector according to (1) or (2), further including, on a side of the first base opposite to the first photoelectric conversion element, a second base in which one or more circuits are provided, the one or more circuits being selected from a driving circuit that drives the first photoelectric conversion element and a reading circuit that reads the electric charge resulting from conversion by the first photoelectric conversion element.
(4) The photodetector according to (3), further including a through wiring line that electrically couples the first photoelectric conversion element and the one or more circuits to each other and passes through the first base in a thickness direction.
(5) The photodetector according to (4), in which
   the first base includes a first semiconductor substrate on which the second photoelectric conversion element is provided, and a first insulating layer provided on a side of the first semiconductor substrate closer to the second base, and
   the photodetector further includes a light shield body provided along a periphery of the second photoelectric conversion element as viewed from the light incident side, the light shield body passing through at least the first semiconductor substrate in the thickness direction and blocking the carrier generated from the second photoelectric conversion element.
(6) The photodetector according to (5), in which
   the through wiring line is provided around the second photoelectric conversion element as viewed from the light incident side, and
   the light shield body is provided between the second photoelectric conversion element and the through wiring line.
(7) The photodetector according to (5) or (6), in which the light shield body is extended into the first insulating layer.
(8) The photodetector according to (5) or (6), in which
   the second base includes a second semiconductor substrate in which the one or more circuits are provided and a second insulating layer provided on a side of the second semiconductor substrate opposite to the first base, and
   the light shield body is extended into the second semiconductor substrate.
(9) The photodetector according to (5) or (6), in which
   the second base includes a second semiconductor substrate in which the one or more circuits are provided and a second insulating layer provided on a side of the second semiconductor substrate opposite to the first base, and
   the light shield body is extended to pass through the second semiconductor substrate in the thickness direction.
(10) The photodetector according to (4), in which a plurality of the through wiring lines is arranged along a periphery of the second photoelectric conversion element as viewed from the light incident side, and is formed as a light shield body that blocks the carrier generated from the second photoelectric conversion element.
(11) The photodetector according to (10), in which one of the through wiring lines and another one of the through wiring lines that are adjacent to each other in an arrangement direction are arranged with their respective portions overlapping with each other as viewed from the second photoelectric conversion element.
(12) The photodetector according to (5), further including a first insulator between the through wiring line and the light shield body, the first insulator being higher in withstand voltage than the first insulating layer.
(13) The photodetector according to (5), further including a second insulator between the through wiring line and the light shield body, the second insulator being lower in permittivity than the first insulating layer.
(14) The photodetector according to any one of (1) to (13), in which
   the first photoelectric conversion element includes an organic photoelectric conversion layer, and
   the second photoelectric conversion element includes an avalanche diode.
(15) The photodetector according to (4), in which
   the second photoelectric conversion element includes an avalanche diode including an anode electrode and a cathode electrode, and
   the photodetector further includes a shield body to be supplied with a fixed potential, the shield body surrounding the cathode electrode.
(16) The photodetector according to any one of (1) to (15), in which
   the first photoelectric conversion element converts visible light into the electric charge, and
   the second photoelectric conversion element generates the carrier from infrared light.
(17) A photodetector including:
   a first base including a first semiconductor substrate, and a first insulating layer stacked on the first semiconductor substrate;
   a second photoelectric conversion element provided in the first base and including a multiplication region that multiplies a carrier generated by a photon; and
   a light shield body provided along a periphery of the second photoelectric conversion element as viewed from a light incident side, the light shield body passing through at least the first semiconductor substrate in a thickness direction and blocking the carrier generated from the second photoelectric conversion element.
(18) The photodetector according to (17), in which the light shield body is extended into the first insulating layer.
(19) The photodetector according to (17), further including
   a second base provided on a side of the first base closer to the first insulating layer and including a second semiconductor substrate and a second insulating layer, the second insulating layer being provided on a side of the second semiconductor substrate opposite to the first base, in which
   the light shield body is extended into the second semiconductor substrate.
(20) The photodetector according to (17), further including
   a second base provided on a side of the first base closer to the first insulating layer and including a second semiconductor substrate and a second insulating layer, the second insulating layer being provided on a side of the second semiconductor substrate opposite to the first base, in which
   the light shield body is extended to pass through the second semiconductor substrate in the thickness direction.

The present application claims the benefit of Japanese Priority Patent Application JP2023-059227 filed with the Japan Patent Office on March 31, 2023, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A photodetector comprising:
a first photoelectric conversion element provided on a light incident side of a first base and converting incident light into electric charge; and
a second photoelectric conversion element provided to overlap with the first photoelectric conversion element in the first base and including a multiplication region that multiplies a carrier generated by a photon.

2. The photodetector according to claim 1, wherein the first photoelectric conversion element is stacked on the second photoelectric conversion element in a light incident direction.

3. The photodetector according to claim 1, further comprising, on a side of the first base opposite to the first photoelectric conversion element, a second base in which one or more circuits are provided, the one or more circuits being selected from a driving circuit that drives the first photoelectric conversion element and a reading circuit that reads the electric charge resulting from conversion by the first photoelectric conversion element.

4. The photodetector according to claim 3, further comprising a through wiring line that electrically couples the first photoelectric conversion element and the one or more circuits to each other and passes through the first base in a thickness direction.

5. The photodetector according to claim 4, wherein
the first base includes a first semiconductor substrate on which the second photoelectric conversion element is provided, and a first insulating layer provided on a side of the first semiconductor substrate closer to the second base, and
the photodetector further comprises a light shield body provided along a periphery of the second photoelectric conversion element as viewed from the light incident side, the light shield body passing through at least the first semiconductor substrate in the thickness direction and blocking the carrier generated from the second photoelectric conversion element.

6. The photodetector according to claim 5, wherein
the through wiring line is provided around the second photoelectric conversion element as viewed from the light incident side, and
the light shield body is provided between the second photoelectric conversion element and the through wiring line.

7. The photodetector according to claim 5, wherein the light shield body is extended into the first insulating layer.

8. The photodetector according to claim 5, wherein
the second base includes a second semiconductor substrate in which the one or more circuits are provided and a second insulating layer provided on a side of the second semiconductor substrate opposite to the first base, and
the light shield body is extended into the second semiconductor substrate.

9. The photodetector according to claim 5, wherein
the second base includes a second semiconductor substrate in which the one or more circuits are provided and a second insulating layer provided on a side of the second semiconductor substrate opposite to the first base, and
the light shield body is extended to pass through the second semiconductor substrate in the thickness direction.

10. The photodetector according to claim 4, wherein a plurality of the through wiring lines is arranged along a periphery of the second photoelectric conversion element as viewed from the light incident side, and is formed as a light shield body that blocks the carrier generated from the second photoelectric conversion element.

11. The photodetector according to claim 10, wherein one of the through wiring lines and another one of the through wiring lines that are adjacent to each other in an arrangement direction are arranged with their respective portions overlapping with each other as viewed from the second photoelectric conversion element.

12. The photodetector according to claim 5, further comprising a first insulator between the through wiring line and the light shield body, the first insulator being higher in withstand voltage than the first insulating layer.

13. The photodetector according to claim 5, further comprising a second insulator between the through wiring line and the light shield body, the second insulator being lower in permittivity than the first insulating layer.

14. The photodetector according to claim 1, wherein
the first photoelectric conversion element includes an organic photoelectric conversion layer, and
the second photoelectric conversion element includes an avalanche diode.

15. The photodetector according to claim 4, wherein
the second photoelectric conversion element includes an avalanche diode including an anode electrode and a cathode electrode, and
the photodetector further comprises a shield body to be supplied with a fixed potential, the shield body surrounding the cathode electrode.

16. The photodetector according to claim 1, wherein
the first photoelectric conversion element converts visible light into the electric charge, and
the second photoelectric conversion element generates the carrier from infrared light.

17. A photodetector comprising:
a first base including a first semiconductor substrate, and a first insulating layer stacked on the first semiconductor substrate;
a second photoelectric conversion element provided in the first base and including a multiplication region that multiplies a carrier generated by a photon; and
a light shield body provided along a periphery of the second photoelectric conversion element as viewed from a light incident side, the light shield body passing through at least the first semiconductor substrate in a thickness direction and blocking the carrier generated from the second photoelectric conversion element.

18. The photodetector according to claim 17, wherein the light shield body is extended into the first insulating layer.

19. The photodetector according to claim 17, further comprising
a second base provided on a side of the first base closer to the first insulating layer and including a second semiconductor substrate and a second insulating layer, the second insulating layer being provided on a side of the second semiconductor substrate opposite to the first base, wherein
the light shield body is extended into the second semiconductor substrate.

20. The photodetector according to claim 17, further comprising
a second base provided on a side of the first base closer to the first insulating layer and including a second semiconductor substrate and a second insulating layer, the second insulating layer being provided on a side of the second semiconductor substrate opposite to the first base, wherein
the light shield body is extended to pass through the second semiconductor substrate in the thickness direction.
